Europäisches Patentamt

European Patent Office

Office européen des brevets

(19)

(11) Publication number: **0 090 924 B1**

(12) **EUROPEAN PATENT SPECIFICATION**

(45) Date of publication of patent specification: **11.11.87**

(51) Int. Cl.⁴: **G 03 F 7/20, G 03 F 1/00**

(21) Application number: **83101182.0**

(22) Date of filing: **08.02.83**

(54) **Method of increasing the image resolution of a transmitting mask and improved masks for performing the method.**

(30) Priority: **05.04.82 US 365672**

(43) Date of publication of application:
**12.10.83 Bulletin 83/41**

(45) Publication of the grant of the patent:
**11.11.87 Bulletin 87/46**

(84) Designated Contracting States:
**CH DE FR GB IT LI NL SE**

(56) References cited:
**DE-A-2 650 817**
**DE-A-2 835 363**
**FR-A-2 358 688**

**PATENTS ABSTRACTS OF JAPAN, vol. 6, no. 66 (P-112)944r, 27th April 1982**
**PATENTS ABSTRACTS OF JAPAN, vol. 6, no. 129 (P-128)1007r, 15th July 1982**

(73) Proprietor: **International Business Machines Corporation**
**Old Orchard Road**
**Armonk, N.Y. 10504 (US)**

(72) Inventor: **Levenson, Marc David**
**19868 Bonnie Ridge Way**
**Saratoga California 95070 (US)**

(74) Representative: **Burt, Roger James, Dr.**
**IBM United Kingdom Limited Intellectual Property Department Hursley Park**
**Winchester Hampshire SO21 2JN (GB)**

## Description

The present invention relates to methods of increasing the image resolution of a transmitting mask and improved masks for performing the method.

IBM Technical Disclosure Bulletin "Microoptics in a Mask", April 1974, page 3784—85) suggests that focusing properties can be built into a mask comprising a transmitting groove by correctly shaping the side walls of the groove. The bulletin discusses the interference effect produced by the light reflected from the side walls and the incident light and demonstrates that by adjusting the wavelength of the exposure radiation constructive interference can be obtained at the centre of the groove.

US—A—3,942,981 to Sato, describes a photomask using a raised transparent region formed on a transparent mask substrate. Light passing through the marginal edges of the raised transparent region will be refracted so as to form a shadow on the surface to be exposed. The use of this mask will result in a pattern in the shape of the perimeter of the raised transparent region. The purpose is to produce very narrow width line images.

US—A—3,615,449 to Greenaway discloses a very specific exposure technique in which the mask is formed as a diffraction grating. The substrate to be exposed is placed in the diffraction grating image plane and the diffraction image is used to expose the substrate.

DE—A—2,650,817 discloses a process for the manufacture of a phase mask with amplitude structure for an optical storage medium or for masks for optical symbol identification, which employ photo-lithographic and vapour deposit techniques, wherein first an amplitude structure is applied to the base, in accordance with the known lithographic processes, and that then the negative of a phase structure is precisely positioned and imprinted into a photo-lacquer-film, applied on top of the amplitude structure, and finally the negative is coated with an optical delay layer of defined thickness and the positive of the phase structure obtained, by removing the lacquer from the negative structure.

The foregoing prior art are all directed at improving the resolution of the image formed by exposure techniques using masks comprising zones of different transmittivity. In general those prior art techniques go some way to meeting their objects but do not provide a wholly satisfactory commercially usable technique.

It is therefore a prime object of the present invention to provide a better method of improving the resolution of an image formed by the use of a mask comprising zones of different transmittivity.

Accordingly, the invention provides a method of improving the resolution of an image formed by projecting at least partially coherent light through a mask which method comprises projecting the light through a mask having opaque and transmitting zones wherein the material in every other transmitting zone has refractive index $n_1$ and that in remaining transmitting zones has refractive index $n_2$, characterised in that the transmitting material in said every other transmitting zone has thickness $d_1$ and in said remaining transmitting zones has thickness $d_2$ such that $n_1d_1 - n_2d_2 = \Phi\lambda$ where $\lambda$ is the wavelength of the incident light and $\Phi$ is a fraction between 1/4 and 3/4.

It is further object of the invention to provide an improved mask for use in the foregoing method.

Such masks according to the present invention are as claimed in appended claims 3 and 4.

The masks of the present invention are intended for use with light which is at least partially coherent. The symbol $\sigma$ is customarily used in the art as a measure of the incoherency of light. When $\sigma$ is equal to 0, the light is totally coherent. When $\sigma$ is equal to infinity, there is total incoherence. The masks of the present invention are preferably used with $\sigma$ less than 1, most preferably less than 0.7. In practice, laser light which is totally coherent is used to best advantage, but the invention is also advantageous for use with partially coherent light.

As mentioned above, $\Phi$ is a fraction between 1/4 and 3/4. It is most preferred that $\Phi$ be 1/2.

The transparent material may be either organic or inorganic. Useful materials include, for example, inorganics such as magnesium fluoride, titanium dioxide and silicon dioxide, and also organics, particularly polymeric materials. A preferred material is poly(methyl methacrylate).

The invention will now be further described with reference to the accompanying drawings, in which:—

Figure 1 is a schematic representation of the use of a conventional mask.

Figure 2 is a schematic representation of the use of a mask embodying the present invention.

In these Figures E is the electric field amplitude of the light and I is the intensity of the light.

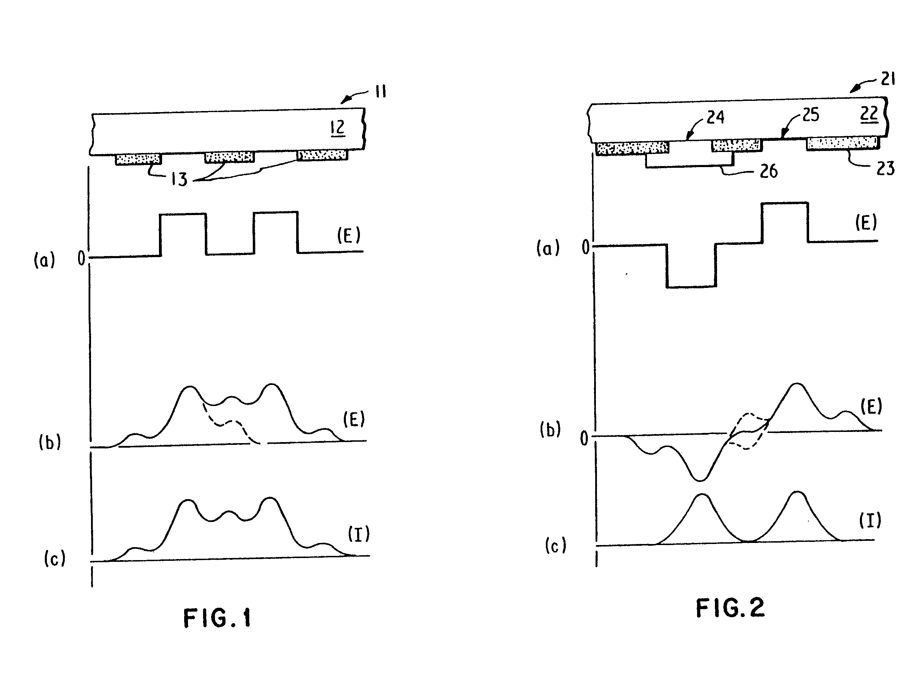

For fully coherent light, the electric fields due to the waves diffracted from individual adjacent apertures must be summed and then squared to yield the intensity. Constructive interference between the fields diffracted by the two apertures maximizes the intensity between them, thereby reducing the resolution of any optical system with coherent illumination. Figure 1 illustrates this case, which approximates the situation in most conventional projection lithography exposure tools.

When it is arranged so that the waves transmitted through adjacent apertures are 180° out of phase with one another, destructive interference minimizes the intensity between their images. Such a situation occurs in the masks of the present invention when the proper transparent material covers every other aperture, as in Figure 2. Any given optical system will project the images of such a phase shifting transmission object with better resolution and higher contrast than a corresponding transmission object without phase shifts. The resulting improvement in resolution and contrast is highly valuable in fine line optical lithography.

A doubling of resolution for illumination with partial coherence σ <0.3 and substantial improvement in resolution for σ <0.7 are obtained. Results obtained with a phase shifting mask patterned with typical device structures by electron beam lithography and, exposed using a Mann 4800 10x tool reveals a 40% increase in usable resolution with same structures printed at a rsolution of 1000 l/mm. Phase shifting mask structures can facilitate proximity printing with larger gaps between mask and wafer. Thus the phase shifting mask is a very desirable device for enhancing optical lithography resolution in the very large scale integration era.

In Figure 1, a transmission mask 11 comprises a glass substrate 12 carrying opaque masking zones 13 formed of deposited chromium. The incident light is monochromatic and coherent e.g. is provided by a laser. Graph (a) represents the magnitude of the electric vector E of the light wavefront as it leaves the mask and graph (b) represents the same quantity at the image plane, that is at the plane of the photo-resist on the wafer to be processed. Graph (c) represents the light intensity in the image at the image plane. As can be seen there is a decrease in intensity between the main peaks but it has a peak amplitude about 3/4 of the main peaks.

Figure 2 shows a transmission mask 21 comprising a glass substrate 22 again carrying opaque chrome masking zones 23. Two adjacent transmitting zones 24, 25 are shown. The zone 24 has a different optical characteristic to that of the adjacent zone 25. This difference is introduced by the layer or covering 26 introduced into the zone 24 and overlapping the adjacent margins of the opaque zones 23. The layer 26 is formed of a transparent material which has a different refractive index to the material, that is air, filling the zone 25. In this example the material is poly-(methyl methacrylate).

Graphs (b), (c) and (d) of Figure 2 correspond to those of Figure 1 and as can be seen the intensity between the main peaks in Figure 2(c) decreases substantially to zero. Thus, there is a clear resolution between the two images of the slots or zones 24, 25. It is to be noted that although only two zones 24, 25 are shown in Figure 2 the mask comprises a multiplicity of such adjacent zones.

The layer 26 has a thickness (d) perpendicular to the glass substrate between the zones 24, 25 given by the relationship

$$(n-1)d = \Phi\lambda$$

where $n$ is the refractive index, $\lambda$ is the wavelength of the light and $\Phi$ is between 1/4 and 3/4. In this example $\Phi$ has the value 1/2.

The transparent material may be either over or under every other transmitting region of the mask. The production mask thus must be made in two steps, one in which the opaque film defining the intensity patterns is drawn, and another in which the phase shifting pattern is projected. The latter requires a resolution less than the former, but must be accurately overlaid. Either step can be done first. For depth-of-focus reasons, it may be better to deposit the phase shifting patterns on top of the intensity pattern, while for reasons of scattered light the reverse may be better. A three-step procedure will allow the deposition of two phase shifting materials with different n's which would yield a mask without surface topography. However, it is clear that preparation of a production mask now requires preparation of at least two preliminary patterns, one for the intensity pattern, one for the phase pattern, accurate overlay, and additional processing. The precision with which the thickness is controlled is similar to that achieved in anti-reflection coatings of aerial camera lenses. A typical processing sequence is:

1. Coat substrate with chromium and overcoat with resist.
2. Expose intensity defining layer.
3. Develop resist.
4. Etch away chromium and remove excess resist.
5. Coat with resist for phase layer.
6. Expose for phase layer.
7. Develop resist.
8. Evaporate phase shifting layer onto mask.
9. Remove photoresist and phase-shifting layer on top of resist.

It is desirable sometimes to use the resist itself as a phase shifting medium.

It is to be understood that the apertures in a practical mask will have a variety of spacings and geometries. When the spacing between a particular pair of apertures is sufficiently large, no significant improvement in resolution can be expected, even should the light passing through one of the pair also pass through a phase shifting layer. In such a case, the pattern of the phase shifting layer may be designed to fullfil some additional consideration even though the result of such a design is to leave two nominally adjacent apertures either both with or both without a phase shifting layer positioned over or under them.

In the present invention, the phase shifting layer may have two or more different thicknesses $d_1$, $d_2$, etc. and particular adjacent apertures would be overlaid or underlaid by phase shifting layers of different thickness such that $(n-1)(d_1-d_2)=\Phi\lambda$. Other apertures may lack a phase shifting layer entirely; should an aperture with phase shifting layer of thickness $d_1$ be adjacent to one such bare aperture, the former condition $(n-1)d_1=\Phi\lambda$ shall apply. Clearly in this variation, different values of $\Phi$ may be applicable to different pairs of apertures. Adjacent apertures may have phase shifting layers positioned above or below composed of different materials as well as possibly having different thicknesses. In a special case of the invention $d_1=d_2$ and thus the surface of the phase shifting layer, is flat.

## Claims

1. A method of improving the resolution of an image formed by projecting at least partially coherent light through a mask which method comprises projecting the light through a mask having opaque and transmitting zones wherein the material in every other transmitting zone has refractive index $n_1$ and that in remaining transmitting zones has refractive index $n_2$, characterised in that the transmitting material in said every other transmitting zone has thickness $d_1$ and in said remaining transmitting zones has thickness $d_2$ such that $n_1d_1-n_2d_2=\Phi\lambda$ where $\lambda$ is the wavelength of the incident light and $\Phi$ is a fraction between 1/4 and 3/4.

2. A method as claimed in claim 1, wherein the material in said every other transmitting zone has refractive index n, the remaining transmitting zones are bare, and the transmitting material has thickness d such that $(n-1)d=\Phi\lambda$.

3. A mask for use with incident light which is at least partially coherent, said mask comprising opaque zones and transmitting zones in which a first transparent material is positioned over or under every other transmitting zone wherein the first transparent material has an index of refraction $n_1$ and a thickness $d_1$ and a second transparent material is positioned over or under the remaining transmitting zones wherein the second transparent material has index of refraction $n_2$ and a thickness $d_2$ such that $n_1d_1-n_2d_2=\Phi\lambda$ where $\lambda$ is the wavelength of the incident light and $\Phi$ is a fraction between 1/4 and 3/4.

4. A mask for use with incident light which is at least partially coherent, said mask comprising opaque zones and transmitting zones in which a transparent material is positioned over or under every other transmitting zone, the remaining transmitting zones are bare and the transparent material has an index of refraction n and a thickness d such that $(n-1)d=\Phi\lambda$ where $\lambda$ is the wavelength of the incident light and $\Phi$ is a fraction between 1/4 and 3/4.

5. A mask as claimed in claim 3 or 4, further characterised in that $\Phi$ is 1/2.

6. A mask as claimed in any of claims 3 to 5, further characterised in that the transmitting material is a polymeric material.

7. A mask as claimed in claim 6, further characterised in that the transmitting material is poly-(methyl methacrylate).

8. A mask as claimed in any of claims 3 to 7 for use in photolithography.

## Patentansprüche

1. Verfahren zur Verbesserung der Auflösung eines Bildes, welches durch Einstrahlen von wenigstens teilweise kohärentem Licht durch eine Maske gebildet ist, wobei das Verfahren das Einstrahlen des Lichtes durch eine Maske mit undurchlässigen und durchlässigen Zonen, bei welchen das Material in jeder zweiten durchlässigen Zone einen Brechungsindex $n_1$ und dasjenige in verbleibenden durchlässigen Zonen einen Brechungsindex $n_2$ hat, umfaßt, dadurch gekennzeichnet, daß das durchlässige Material in der jeder zweiten durchlässigen Zone eine Dicke $d_1$ und in den verbleibenden durchlässigen Zonen eine Dicke $d_2$ hat, derart, daß $n_1d_1-n_2d_2=\Phi\lambda$, wobei $\lambda$ die Wellenlänge des einfallenden Lichts und $\Phi$ ein Bruch zwischen 1/4 und 3/4 ist.

2. Verfahren nach Anspruch 1, bei welchem das Material in der jeder zweiten durchlässigen Zone einem Brechungsindex n hat, die verbleibenden durchlässigen Zonen nackt sind und das durchlässige Material eine Dicke d hat, derart, daß $(n-1)d=\Phi\lambda$ ist.

3. Maske zur Verwendung mit einfallendem Licht, welches wenigstens teilweise kohärent ist, wobei die Maske undurchlässige Zonen und durchlässige Zonen umfaßt, bei welchen ein erstes transparentes Material über oder unter jeder zweiten durchlässigen Zone angeordnet ist, wobei das erste transparente Material einen Brechungsindex $n_1$ und eine Dicke $d_1$ hat und ein zweites transparentes Material über oder unter de verbleibenden durchlässigen Zonen angeordnet ist, wobei das zweite transparente Material einen Brechungsindex $n_2$ und eine Dicke $d_2$ hat, derart, daß $n_1d_1-n_2d_2=\Phi\lambda$, wobei $\lambda$ die Wellenlänge des einfallenden Lichts und $\Phi$ ein Bruch zwischen 1/4 und 3/4 ist.

4. Maske zur Verwendung mit einfallendem Licht, welches wenigstens teilweise kohärent ist, wobei die Maske undurchlässige und durchlässige Zonen umfaßt, bei welchen ein transparentes Material über und unter jeder zweiten durchlässigen Zone angeordnet, ist, die übrigen durchlässigen Zonen nackt sind und das transparente Material einen Brechungsindex n und eine Dicke d hat, derart, daß $(n-1)d=\Phi\lambda$, wobei $\lambda$ die Wellenlänge des einfallenden Lichts und $\Phi$ ein Bruch zwischen 1/4 und 3/4 ist.

5. Maske nach Anspruch 3 oder 4, ferner dadurch gekennzeichnet, daß $\Phi$ gleich 1/2 ist.

6. Maske nach irgendeinem der Ansprüche 3 bis 5, ferner dadurch gekennzeichnet, daß das durchlässige Material ein Polymermaterial ist.

7. Maske nach Anspruch 6, ferner dadurch gekennzeichnet, daß das durchlässige Material Polymethylmethacrylat ist.

8. Maske nach irgendeinem der Ansprüche 3 bis 7 zur Verwendung in der Photolithographie.

## Revendications

1. Un procédé pour améliorer la résolution d'une image formée par projection à travers un masque d'une lumière au moins partiellement cohérente, ce procédé comprenant la projection de la lumière à travers un masque comportant des zones opaques et de transmission, dans lequel la matière se trouvant dans une zone de transmission deux présente un indice de réfraction $n_1$ et celle se trouvant des les zones de transmission restantes possède un indice de réfraction $n_2$, caractérisé en ce que la matière de transmission se trouvant dans une zone de transmission sur deux a une épaisseur $d_1$ et celle se trouvant dans les zones de transmission restantes a une épaisseur $d_2$, de façon que $n_1d_1-n_2d_2=\Phi\lambda$, en désignant par $\lambda$ la longueur d'onde de la lumière incidente et par $\Phi$ une fraction comprise entre 1/4 et 3/4.

2. Un procédé selon la revendication 1, dans lequel la matière se trouvant dans une zone de transmission sur deux a un indice de réfraction égal à n, les zones de transmission restantes sont nues, et la matière de transmission a une épaisseur d telle que $(n-1)d=\Phi\lambda$.

3. Un masque prévu pour l'utilisation avec de la lumière incidente qui est au moins partiellement cohérente, ce masque comportant des zones opaques et des zones de transmission dans lesquelles une première matière transparente est placées au-dessus ou au-dessous d'une zone de transmission sur deux, la première matière transparente ayant un indice de réfraction $n_1$ et une épaisseur $d_1$, et une seconde matière transparente est placée au-dessus ou au-dessous des zones de transmission restantes, la seconde matière transparente ayant un indice de réfraction $n_2$ et une épaisseur $d_2$ telles que $n_1d_1-n_2d_2=\Phi\lambda$, en désignant par $\lambda$ la lonqueur d'onde de la lumière incidente et par $\Phi$ une fraction comprise entre 1/4 et 3/4.

4. Un masque prévu pour l'utilisation avec de la lumière incidente qui est au moins partiellement cohérente, ce masque comprenant des zones opaques et des zones de transmission, dans lesquelles une matière transparente est placée au-dessus ou au-dessous d'une zone de transmission sur deux, les zones de transmission restantes sont nues, et la matière transparente présente un indice de réfraction n et une épaisseur d telles que $(n-1)d=\Phi\lambda$, en désignant par $\lambda$ la longueur d'onde de la lumière incidente et par $\Phi$ une fraction comprise entre 1/4 et 3/4.

5. Un masque selon lar revendication 3 ou 4, caractérisé en outre en ce que $\Phi$ est égal à 1/2.

6. Un masque selon l'une quelconque des revendications 3 à 5, caractérisé en outre en ce que la matière de transmission est un polymère.

7. Un masque selon la revendication 6, caractérisé en outre en ce que la matière de transmission est du poly(méthacrylate de méthyle).

8. Un masque selon l'une quelconque des revendications 3 à 7, prévu pour l'utilisation en photolithographie.

FIG.1

FIG.2

0 090 924